(19) Europäisches Patentamt
European Patent Office
Office européen des brevets

(11) **EP 3 921 875 B1**

(12) **FASCICULE DE BREVET EUROPEEN**

(45) Date de publication et mention de la délivrance du brevet:
**18.03.2026 Bulletin 2026/12**

(21) Numéro de dépôt: **20710212.0**

(22) Date de dépôt: **04.02.2020**

(51) Classification Internationale des Brevets (IPC):
***H10N 10/853*** [(2023.01)]

(52) Classification Coopérative des Brevets (CPC):
**H10N 10/853**

(86) Numéro de dépôt international:
**PCT/FR2020/050187**

(87) Numéro de publication internationale:
**WO 2020/161435 (13.08.2020 Gazette 2020/33)**

(54) **COMPOSÉ THERMOÉLECTRIQUE À BASE D'ANTIMONIURE DE MAGNÉSIUM DOPÉ DE TYPE N**

THERMOELEKTRISCHE VERBINDUNG AUF DER BASIS VON N-DOTIERTEM MAGNESIUMANTIMONID

THERMOELECTRIC COMPOUND BASED ON N-DOPED MAGNESIUM ANTIMONIDE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.02.2019 FR 1901067**

(43) Date de publication de la demande:
**15.12.2021 Bulletin 2021/50**

(73) Titulaire: **IMRA Europe SAS**
**06560 Valbonne (FR)**

(72) Inventeurs:
• **PERE, Daniel**
**06800 Cagnes Sur Mer (FR)**
• **DELATOUCHE, Bruno**
**06560 Valbonne (FR)**
• **CHMIELOWSKI, Radoslaw**
**06250 Mougins (FR)**

(74) Mandataire: **Weinstein Services & Conseils**
**2-10, avenue Marc Sangnier**
**92390 Villeneuve la Garenne (FR)**

(56) Documents cités:
• **ZHANG JIAWEI ET AL: "High-Performance Low-Cost n-Type Se-Doped Mg 3 Sb 2 -Based Zintl Compounds for Thermoelectric Application", CHEMISTRY OF MATERIALS, vol. 29, no. 12, 27 June 2017 (2017-06-27), US, pages 5371 - 5383, XP093186652, ISSN: 0897-4756, DOI: 10.1021/ acs.chemmater.7b01746**
• **HIROMASA TAMAKI ET AL: "Isotropic Conduction Network and Defect Chemistry in Mg3+[delta]Sb2-Based Layered Zintl Compounds with High Thermoelectric Performance", ADVANCED MATERIALS, VCH PUBLISHERS, DE, vol. 28, no. 46, 30 September 2016 (2016-09-30), pages 10182 - 10187, XP071817530, ISSN: 0935-9648, DOI: 10.1002/ ADMA.201603955**
• **GORAI PRASHUN ET AL: "Effective n-type doping of Mg3Sb2 with group-3 elements", JOURNAL OF APPLIED PHYSICS, AMERICAN INSTITUTE OF PHYSICS, US, vol. 125, no. 2, 8 January 2019 (2019-01-08), XP012234470, ISSN: 0021-8979, [retrieved on 20190108], DOI: 10.1063/ 1.5081833**
• **KAZUKI IMASATO ET AL: "Improved stability and high thermoelectric performance through cation site doping in n-type La-doped Mg 3 Sb 1.5 Bi 0.5", JOURNAL OF MATERIALS CHEMISTRY A, vol. 6, no. 41, 23 October 2018 (2018-10-23), GB, pages 19941 - 19946, XP055627532, ISSN: 2050-7488, DOI: 10.1039/C8TA08975B**

- LING ET AL: "Effect of Neodymium on Microstructure and Mechanical Properties of Mg-Sb Alloy", JOURNAL OF RARE EARTHS, INTERNATIONAL ACADEMIC PUBLISHERS, BEIJING, CN, vol. 24, no. 1, 1 December 2006 (2006-12-01), pages 376 - 378, XP022933842, ISSN: 1002-0721, [retrieved on 20061201], DOI: 10.1016/S1002-0721(07)60405-0

**Description**

DOMAINE TECHNIQUE

L'invention concerne principalement un composé thermoélectrique à base d'antimoniure de magnésium dopé de type n.

ART ANTERIEUR

L'effet thermoélectrique est un phénomène physique présent dans certains matériaux qui lie le flux de chaleur qui les traverse à la puissance électrique qui les parcourt.

Les matériaux thermoélectriques ont ainsi la double capacité de générer une puissance électrique lorsqu'ils sont exposés à un gradient de température (effet Seebeck), et de générer un flux de chaleur lorsqu'un courant électrique leur est appliqué dans la masse (effet Peltier).

Les performances des matériaux thermoélectriques dépendent de la gamme de température dans lesquelles ils sont utilisés. On s'intéresse dans la présente invention à des matériaux thermoélectriques dont les applications mettent en jeu des températures comprises entre 300K et 800K.

L'antimoniure de magnésium ($Mg_3Sb_2$) est un matériau thermoélectrique connu de type n. Il a été démontré que pour obtenir des facteurs de mérite élevés (zT), ce matériau nécessite d'être fabriqué avec une importante sur-stœchiométrie en magnésium ainsi qu'un dopage par des éléments de la colonne 16 du tableau périodique tels que le sélénium ou le tellure. Dans ces conditions de fabrication, le facteur de mérite (zT) peut atteindre des valeurs de l'ordre de 0,8 à 1,2 à 723K. Ces phénomènes sont décrits notamment dans les publications Ohno et al, Phase boundary mapping to obtain n-type Mg3Sb2-based thermoelectrics, Joule 2, 141-154, 2018, et Zhang et al, High-Performance Low-Cost n-Type Se-Doped Mg3Sb2-Based Zintl Compounds for Thermoelectric Application, Chem. Mater., 29, 5371-5383, 2017.

Il est également connu que l'alliage avec le bismuth sur le site de l'antimoine formant un matériau thermoélectrique de type $Mg_3(Sb,Bi)_2$ avec un dopage ou co-dopage au tellure permet de réduire considérablement la conductivité thermique et ainsi augmenter substantiellement le facteur de mérite jusqu'à 1.6 à 723K. Ces matériaux sont évoqués notamment dans les publications Tamaki et al., Isotropic Conduction Network and Defect Chemistry in Mg3+δSb2-Based Layered Zintl Compounds with High Thermoelectric Performance, Adv. Mater. 2016, 28, 10182-10187 et Chen et al., Extraordinary thermoelectric performance in n-type manganese doped Mg3Sb2 Zintl: High band degeneracy, tuned carrier scattering mechanism and hierarchical microstructure, Nano Energy 52, 246-255, 2018.

Il est ainsi connu d'augmenter les performances des matériaux thermoélectriques de type $Mg_3Sb_2$ et $Mg_3(Sb,Bi)_2$ par dopage ou co-dopage au tellure ou au sélénium. Si des facteurs de puissance élevés d'environ 20 $\mu W.cm^{-1}.K^{-2}$ résultant de l'augmentation de la densité des porteurs de charge du matériau sont obtenus, le tellure et le sélénium sont aujourd'hui identifiés et considérés comme des éléments toxiques. La publication GORAI PRASHUN ET AL: "Effective n-type doping of Mg3Sb2 with group-3 elements",JOURNAL OF APPLIED PHYSICS, AMERICAN INSTITUTE OF PHYSICS, US, vol. 125, no. 2, 8 janvier 2019 (2019-01-08), XP012234470,ISSN: 0021-8979, DOI: 10.1063/1.5081833 divulgue des calculs théoriques concernant un composé thermoélectrique à base d'antimoniure de magnésium Mg3 Sb2 dopé de type n, le dopant étant choisi parmi le lanthane (La) et l'yttrium (Y) et ledit composé étant dépourvu de bismuth.

EXPOSE DE L'INVENTION

L'invention vise en premier lieu un composé thermoélectrique présentant au moins les mêmes performances que les composés précités de l'art antérieur, tout en limitant leur caractère toxique.

L'invention vise en second lieu un composé thermoélectrique dont le coût de fabrication est peu élevé.

À cet effet, le composé thermoélectrique de l'invention est à base d'antimoniure de magnésium $Mg_3Sb_2$ dopé de type n, le dopant étant choisi parmi le lanthane, l'yttrium, le cérium, le praséodyme, le néodyme, le gadolinium, l'erbium, le terbium, le thulium et le lutécium, étant un mélange de ces éléments, ou étant du mischmétal, et ledit composé étant dépourvu de bismuth.

Sont ainsi exclus de la portée de la présente invention les composés thermoélectriques de type $Mg_3(Sb,Bi)_2$.

Le composé thermoélectrique de l'invention peut également comporter les caractéristiques optionnelles suivantes considérées isolément ou selon toutes les combinaisons techniques possibles :

- le dopant est choisi parmi l'yttrium, le cérium, le praséodyme, le néodyme, le gadolinium et l'erbium, ou est un mélange de ces éléments,
- le dopant est choisi parmi le cérium, le praséodyme, le néodyme, le gadolinium et l'erbium, ou est un mélange de ces éléments,
- le dopant comprend un mélange d'au moins de cérium, lanthane, néodyme et praséodyme,
- le dopant est du mischmétal, et
- le pourcentage atomique du dopant par rapport aux éléments métalliques est compris entre 0,05 et 1,4% inclus.

## BREVE DESCRIPTION DES DESSINS

D'autres caractéristiques et avantages de l'invention ressortiront clairement de la description qui en est donnée ci-dessous, à titre indicatif et nullement limitatif, en référence aux figures annexées succinctement décrite ci-dessous :

- Figure 1 : Graphique comparant l'évolution du facteur de puissance selon la température pour un composé thermoélectrique de l'invention dopé au lanthane selon des pourcentages atomiques de lanthane par rapport aux éléments métalliques respectivement de 0,2, 0,4, 0,7 et 1,5 % ;
- Figure 2 : Graphique comparant l'évolution de la figure de mérite selon la température pour un composé thermoélectrique de l'invention dopé au lanthane selon des pourcentages atomiques de lanthane par rapport aux éléments métalliques respectivement de 0,2, 0,4, 0,7 et 1,5 % ;
- Figure 3 : Graphique comparant l'évolution du facteur de puissance selon la température pour un composé thermoélectrique de l'invention dopé au cérium selon des pourcentages atomiques de cérium par rapport aux éléments métalliques respectivement de 0,2, 0,4 et 0,7% ;
- Figure 4 : Graphique comparant l'évolution de la figure de mérite selon la température pour un composé thermoélectrique de l'invention dopé au cérium selon des pourcentages atomiques de cérium par rapport aux éléments métalliques respectivement de 0,2, 0,4 et 0,7% ;
- Figure 5 : Graphique comparant l'évolution de la figure de mérite selon la température pour des composés thermoélectriques de l'invention respectivement dopés au lanthane, à l'yttrium, au cérium, au praséodyme, au néodyme, au gadolinium et à l'erbium (pourcentage atomique de dopant par rapport aux éléments métalliques 0,4%) ;
- Figure 6 : Graphique illustrant l'évolution de la figure de mérite selon la température pour un composé thermoélectrique de l'invention dopé au mischmétal (pourcentage atomique de dopant par rapport aux éléments métalliques 0,4%) ; et
- Figure 7 : Graphique illustrant l'évolution du facteur de puissance selon la température pour le composé thermoélectrique de l'invention dopé au mischmétal (pourcentage atomique de dopant par rapport aux éléments métalliques 0,4%),
- Figure 8 : Graphique comparant l'évolution de la figure de mérite selon la température pour des composés thermoélectriques respectivement dopés au lanthane, à l'yttrium, au cérium, au praséodyme, au néodyme, au gadolinium, à l'erbium, au terbium, au lutécium, au thulium, au samarium, au scandium, au dysprosium, à l'ytterbium, à l'holmium et à l'europium (pourcentage atomique de dopant par rapport aux éléments métalliques 0,4%) ;

- Figure 9 : Graphique comparant l'évolution du facteur de puissance selon la température pour des composés thermoélectriques respectivement dopés au lanthane, à l'yttrium, au cérium, au praséodyme, au néodyme, au gadolinium, à l'erbium, au terbium, au lutécium, au thulium, au samarium, au scandium, au dysprosium, à l'ytterbium, à l'holmium et à l'europium (pourcentage atomique de dopant par rapport aux éléments métalliques 0,4%) ;

L'invention sera mieux comprise à la lecture de la description qui suit et à l'examen des figures qui l'accompagnent. Celles-ci sont présentées à titre indicatif et nullement limitatif de l'invention.

## DESCRIPTION DETAILLEE

L'invention se rapporte principalement à un composé thermoélectrique à base d'antimoniure de magnésium de type $Mg_3Sb_2$ dopé de type n, pour lequel le dopant est choisi dans le groupe des terres rares parmi le lanthane, l'yttrium, le cérium, le praséodyme, le néodyme, le gadolinium, l'erbium, le terbium, le thulium et le lutécium, ou un mélange de ces éléments, notamment du mischmétal.

Les terres rares présentent l'avantage, contrairement au tellure ou au sélénium, de ne pas être toxiques. Les inventeurs ont ainsi mis en évidence l'obtention de bonnes performances thermoélectriques du $Mg_3Sb_2$ dopé de type n avec différentes terres rares purifiées.

L'invention se rapporte en outre à ce même composé thermoélectrique à base d'antimoniure de magnésium de type $Mg_3Sb_2$ dopé de type n, pour lequel le dopant est du mischmétal, c'est-à-dire un alliage de terres rares non purifiées.

Contrairement à la littérature qui incite à utiliser des corps purs comme dopant, les inventeurs ont mis en évidence que le mischmétal permet d'obtenir de très bonnes performances thermoélectriques. Le mischmétal présente l'avantage d'être de faible coût, comparé aux terres rares pures soumises à des procédés de purifications couteux.

Un matériau thermoélectrique est caractérisé par sa figure de mérite zT qui s'exprime de la façon suivante :

$$zT = \frac{S^2 \sigma T}{\kappa}$$

où S est le coefficient de Seebeck ($\mu$V.K$^{-1}$)
$\sigma$ est la conductivité électrique (S.m$^{-1}$)
k est la conductivité thermique (W.K$^{-1}$.m$^{-1}$)
T la température (K)

La figure de mérite zT peut également s'exprimer de la façon suivante :

$$zT = \frac{S^2 T}{\rho \, \kappa}$$

où $\rho$ est la résistivité électrique (en $\Omega$.m)

Le facteur de mérite zT a été conçu pour comparer les performances des matériaux thermoélectriques utilisés dans le mode Peltier. Dans le cas de l'utilisation de matériaux thermoélectriques dans le mode Seebeck, c'est-à-dire pour la génération de puissance électrique à partir d'un gradient de température, les performances des matériaux électriques peuvent être illustrées par un facteur de puissance PF qui s'exprime de la façon suivante :

$$PF = S^2 . \, \sigma = S^2 . \rho^{-1}$$

Enfin, la conductivité thermique peut s'exprimer de la façon suivante :

$$K = D . c_p . d$$

Où D est la diffusivité thermique (en $mm^2.s^{-1}$),
$c_p$ est la capacité thermique (en $J.g^{-1}.K^{-1}$)
d est la densité (en $g.cm^{-3}$)

Dans les exemples ci-dessous, les performances des matériaux thermoélectriques de l'invention sont ainsi caractérisées par leur facteur de puissance PF et/ou leur figure de mérite zT.

On décrit ci-après un exemple de réalisation non limitatif du composé thermoélectrique de l'invention.

La synthèse de l'antimoniure de magnésium $Mg_3Sb_2$ est réalisée par des étapes de mécano synthèse suivies d'une étape de compactage par une méthode de frittage également dénommée par le terme anglophone « Spark Plasma Sintering » (SPS).

La première étape de mécanosynthèse consiste à mélanger dans une boite à gants sous atmosphère protectrice des copeaux de magnésium avec le dopant choisi dans le groupe des terres rares tel que précisé précédemment, ou du mischmétal, et de l'acide stéarique. Ce mélange est ensuite enfermé dans un bol de broyage en acier inoxydable étanche avec des billes de 10 mm de diamètre. Cette première étape de mécanosynthèse est réalisée pendant 36 minutes avec des cycles formés chacun d'une minute de marche puis d'une minute arrêt. A chaque changement de cycle, la direction de rotation est inversée. Cette première étape de mécanosynthèse est réalisée à une vitesse de rotation de 300 tours par minute. Lors de la deuxième étape de mécanosynthèse, la vitesse de rotation est augmentée jusqu'à 800 tours par minute. Cette étape est réalisée pendant 4h15 avec des cycles de 15 minutes de marche suivi d'une minute d'arrêt. Le sens de rotation est inversé à chaque changement de cycle. Lors de la troisième étape de mécanosynthèse, la poudre d'antimoine et l'acide stéarique sont ajoutés dans le bol dans une boite à gants sous atmosphère protectrice. Comme pour la première étape de mécanosynthèse, cette troisième étape est réalisée pendant 36 minutes avec des cycles formés chacun d'une minute de marche puis d'une minute arrêt. A chaque changement de cycle, la direction de rotation est inversée. Cette troisième étape de mécanosynthèse est également réalisée à une vitesse de rotation de 300 tours par minute. La quatrième étape de mécanosynthèse est réalisée pendant une durée de 4h15 à 800 tours par minutes avec aussi des cycles de 15 minutes de marche suivi d'une minute d'arrêt. Le sens de rotation est inversé à chaque changement de cycle. La structure cristallographique de la poudre ainsi synthétisée correspond à l'antimoniure de magnésium $Mg_3Sb_2$.

La poudre obtenue est ensuite frittée dans un four SPS (Spark Plasma Sintering) dans un moule en graphite sous une pression de 50MPa. Lors de cette étape, deux paliers sont appliqués. La température du premier palier de 550°C est atteinte en 11 minutes. Puis la température est stabilisée à 550°C pendant 2 minutes. Un second palier de 850°C est atteint en 7 minutes. L'échantillon est enfin maintenu à 850°C pendant 4 minutes.

Pour finir, le voltage et le courant sont arrêtés pour permettre à l'échantillon de refroidir lentement jusqu'à la température ambiante. La surface des pastilles obtenues est ensuite polie pour être nettoyée.

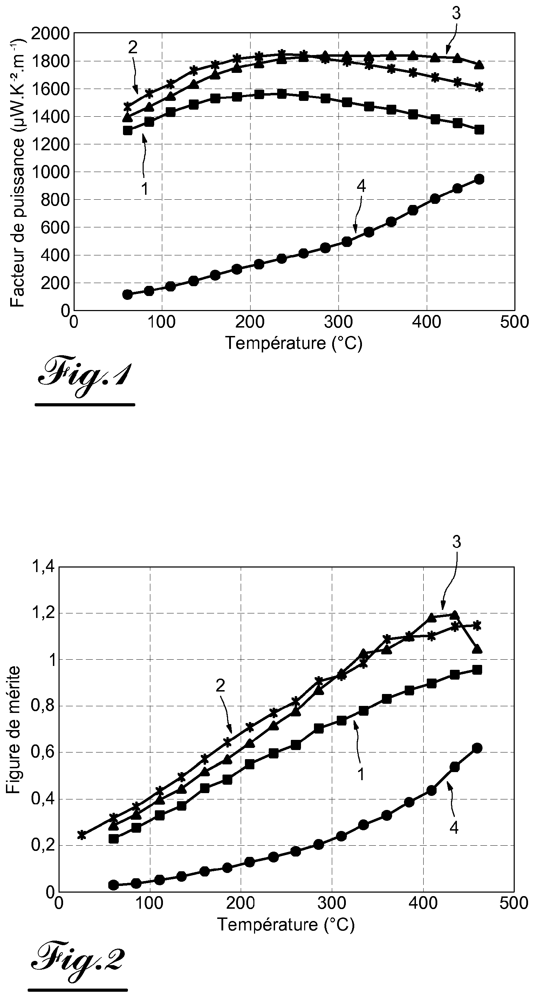

Les figures 1 à 7 décrites ci-après illustrent les performances électriques du composé thermoélectrique de l'invention obtenu selon le procédé précédemment décrit et selon la nature et le pourcentage atomique du ou des dopants.

Les figures 1 et 2 illustrent l'évolution respectivement du facteur de puissance et de la figure de mérite selon la température pour le composé thermoélectrique de l'invention dopé au lanthane selon des pourcentages atomiques de lanthane par rapport aux éléments métalliques respectivement de 0,2, 0,4, 0,7 et 1,5 % (références respectives 1, 2, 3 et 4). On constate que le dopage au lanthane pour des pourcentages atomiques de 0,2, 0,4, 0,7% permet d'obtenir de bonnes performances thermoélectriques, tandis qu'un dopage à 1,5% atomique ne permet pas d'obtenir de résultats satisfaisants.

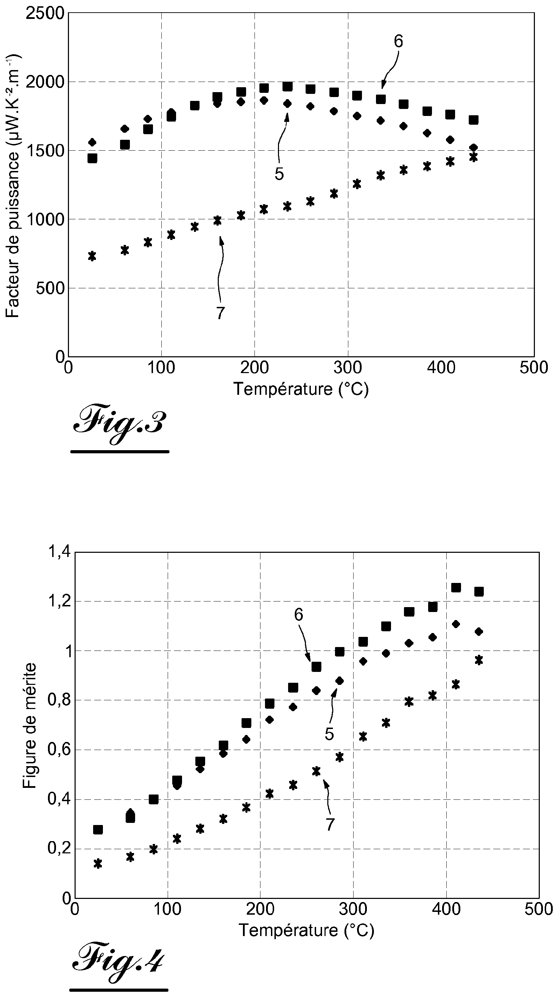

Les figures 3 et 4 illustrent l'évolution respectivement du facteur de puissance et de la figure de mérite selon la température pour le composé thermoélectrique de l'invention dopé au cérium selon des pourcentages atomiques de cérium par rapport aux éléments métalliques respectivement de 0,2, 0,4 et 0,7 % (références respectives 5, 6 et 7). On constate que le dopage au cérium permet également d'obtenir de bonnes performances thermoélectriques, en particulier pour un pourcentage atomique au cérium de 0,4%.

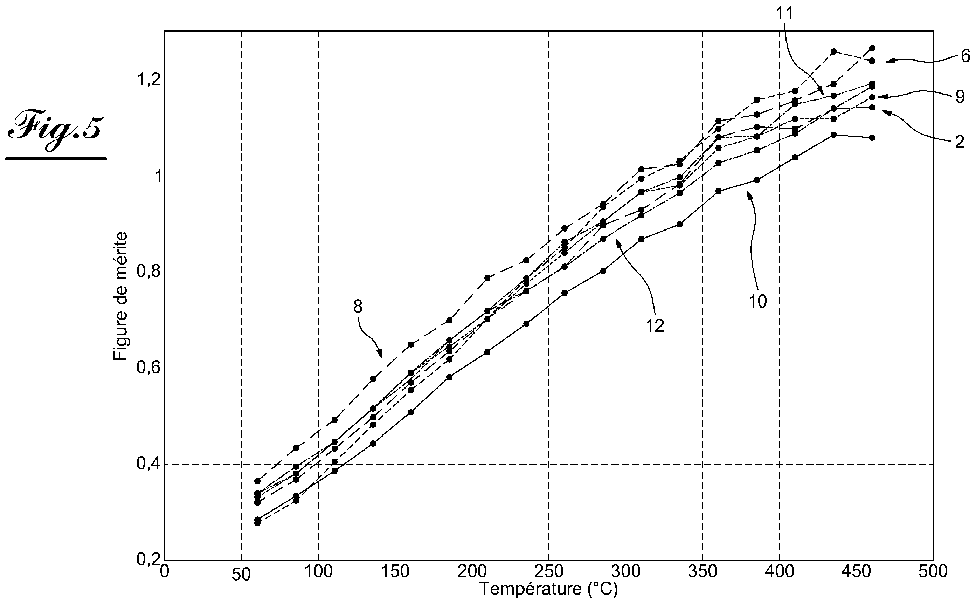

La figure 5 illustre l'évolution de la figure de mérite selon la température pour des composés thermoélectriques de l'invention respectivement dopés au lanthane (référence 2), au cérium (référence 6), à l'yttrium (référence 8), au praséodyme (référence 9), au néodyme (référence 10), au gadolinium (référence 11) et à l'erbium (référence 12) pour un pourcentage atomique de dopage par rapport aux éléments métalliques de 0,4%. On constate que pour tous ces dopants, les performances thermoélectriques obtenues du composé de l'invention sont très satisfaisantes.

Au regard des figures 1 à 5, il est ainsi mis en évidence que le dopage du $Mg_3Sb_2$ avec un dopant choisi parmi certaines terres rares permet d'obtenir de bonnes performances thermoélectriques. Il est plus particulièrement mis en évidence que ces performances sont obtenues pour un dopant choisi parmi le lanthane, l'yttrium, le cérium, le praséodyme, le néodyme, le gadolinium et l'erbium.

Tous ces dopants sont des corps purs qui font l'objet des procédés de purification spécifiques. Il est en effet d'usage d'utiliser des corps purs comme dopant dans les composés thermoélectriques en raison du caractère néfaste des impuretés pour les propriétés thermoélectriques.

Mais les procédés de purification sont coûteux, ce qui augmente substantiellement le coût global du procédé de fabrication des composés thermoélectriques.

Les inventeurs ont mis en évidence que, de façon surprenante, il n'était pas nécessaire d'utiliser des corps purs pour doper l'antimoniure de magnésium et que de bonnes performances thermoélectriques pouvaient être obtenues lorsque le dopant est un mélange de terres rares non purifiées.

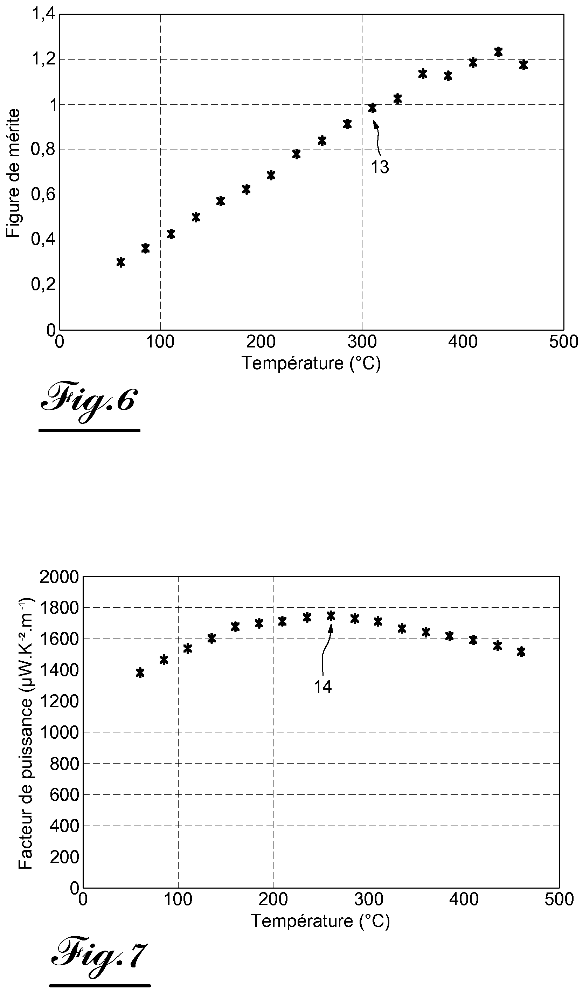

Les figures 6 et 7 illustrent l'évolution respectivement de la figure de mérite (référence 13) et du facteur de puissance (référence 14) selon la température lorsque le composé thermoélectrique de l'invention est dopé avec du mischmétal pour un pourcentage atomique de dopage par rapport aux éléments métalliques de 0,4%.

Le mischmétal est un alliage de terres de rares, connu pour la réalisation des pierres à briquet. Le mischmétal contient essentiellement du cérium, du lanthane, du néodyme et du praséodyme dans des proportions variées. Les terres rares sont isolées à partir du mischmétal par les procédés spécifiques et coûteux évoqués précédemment. Le mischmétal ayant fait l'objet des tests dont les résultats sont présentés en figures 6 et 7 contient environ 73% de cérium, 20,8% de lanthane, 3,7% de néodyme et 1,5% de praséodyme ainsi que moins de 0,5% respectivement de thulium, erbium, dysprosium, lutécium et ytterbium, les pourcentages étant exprimés en concentration atomique. Le coût de fabrication du mischmétal est environ 20 fois inférieur au coût de fabrication du cérium pur.

On constate que lorsque le dopant utilisé est du mischmétal, les performances thermoélectriques du composé de l'invention sont comparables à celles obtenues lorsque le dopant est un corps pur (voir figure 5).

Il a ainsi été mis en évidence d'une part la possibilité d'utiliser un mélange de certaines terres rares comme dopant du $Mg_3Sb_2$, et d'autre part la possibilité d'utiliser des terres rares non purifiées. L'utilisation du mischmétal permet ainsi de réaliser un composé thermoélectrique présentant à la fois de hautes performances thermoélectriques et un faible coût de fabrication.

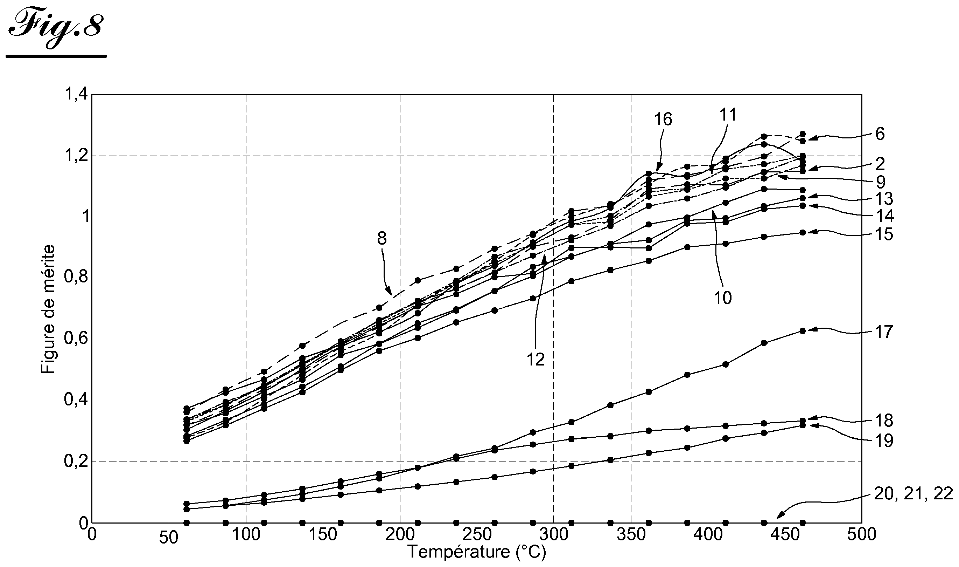

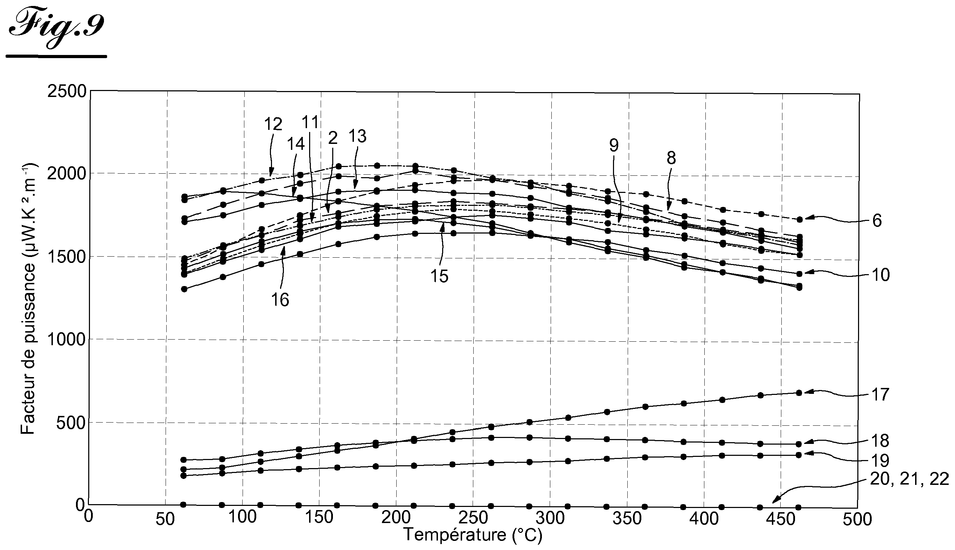

Les figures 8 et 9 illustrent l'évolution de la figure de mérite et du facteur de puissance selon la température pour des composés thermoélectriques de l'invention notamment et respectivement dopés au lanthane (référence 2), au cérium (référence 6), à l'yttrium (référence 8), au praséodyme (référence 9), au néodyme (référence 10), au gadolinium (référence 11), à l'erbium (référence 12), au terbium (référence 13), au lutécium (référence 14), au thulium (référence 15) et au mischmétal (référence 16) pour un pourcentage atomique de dopage par rapport aux éléments métalliques de 0,4%. On constate que pour tous ces dopants, les performances thermoélectriques obtenues du composé de l'invention sont très satisfaisantes.

Les figures 8 et 9 illustrent également l'évolution de la figure de mérite et du facteur de puissance selon la température pour des composés thermoélectriques respectivement dopés au samarium (référence 17), au scandium (référence 18), au dysprosium (référence 19) et à l'ytterbium, à l'holmium et à l'europium (références 20,21,22). On constate que les résultats obtenus pour le samarium, le scandium et le dysprosium sont insuffisants, tandis que les performances thermoélectriques obtenues pour l'ytterbium, à l'holmium et à l'europium sont inexistantes.

## Revendications

**1.** Composé thermoélectrique à base d'antimoniure de magnésium $Mg_3Sb_2$ dopé de type n, **caractérisé en ce que** le dopant étant choisi parmi le lanthane, l'yttrium, le cérium, le praséodyme, le néodyme, le gadolinium, l'erbium, le terbium, le thulium et le lutécium, étant un mélange de ces éléments, ou étant du mischmétal, et ledit composé étant dépourvu de bismuth.

**2.** Composé thermoélectrique selon la revendication 1, **caractérisé en ce que** le dopant est choisi parmi l'yttrium, le cérium, le praséodyme, le néodyme, le gadolinium et l'erbium, ou est un mélange de ces éléments

**3.** Composé thermoélectrique selon la revendication 2, **caractérisé en ce que** le dopant est choisi parmi le cérium, le praséodyme, le néodyme, le gadolinium et l'erbium, ou est un mélange de ces éléments.

**4.** Composé thermoélectrique selon la revendication 1, **caractérisé en ce que** le dopant comprend un mélange d'au moins de cérium, lanthane, néodyme et praséodyme.

5. Composé thermoélectrique selon la revendication 1, **caractérisé en ce que** le dopant est du mischmétal.

6. Composé thermoélectrique selon l'une quelconque des revendications précédentes, **caractérisé en ce que** le pourcentage atomique du dopant par rapport aux éléments métalliques est compris entre 0,05 et 1,4% inclus.

**Patentansprüche**

1. Thermoelektrische Verbindung auf der Basis von n-dotiertem Magnesiumantimonid ($Mg_3Sb_2$), **dadurch gekennzeichnet, daß** das Dotiermittel ausgewählt ist aus Lanthan, Yttrium, Cer, Praseodym, Neodym, Gadolinium, Erbium, Terbium, Thulium und Lutetium, wobei es sich um ein Gemisch dieser Elemente oder Mischmetall handelt, und wobei die Verbindung bismutfrei ist

2. Thermoelektrische Verbindung nach Anspruch 1, **dadurch gekennzeichnet, daß** das Dotiermittel ausgewählt ist aus Yttrium, Cer, Praseodym, Neodym, Gadolinium und Erbium oder ein Gemisch dieser Elemente ist.

3. Thermoelektrische Verbindung nach Anspruch 2, **dadurch gekennzeichnet, daß** das Dotiermittel ausgewählt ist aus Cer, Praseodym, Neodym, Gadolinium und Erbium oder ein Gemisch dieser Elemente ist.

4. Thermoelektrische Verbindung nach Anspruch 1, **dadurch gekennzeichnet, daß** das Dotiermittel ein Gemisch mindestens aus Cer, Lanthan, Neodym und Praseodym umfasst.

5. Thermoelektrische Verbindung nach Anspruch 1, **dadurch gekennzeichnet, daß** das Dotiermittel Mischmetall ist.

6. Thermoelektrische Verbindung nach einem der vorhergehenden Ansprüche, **dadurch gekennzeichnet, daß** der Atomprozentsatz des Dotiermittels mit Bezug auf die metallischen Elemente im Bereich zwischen einschließlich 0,05 und 1,4 % liegt.

**Claims**

1. A thermoelectric compound based on n-type doped magnesium antimonide $Mg_3Sb_2$, **characterized in that** the dopant being chosen from among lanthanum, yttrium, cerium, praseodymium, neodymium, gadolinium, erbium, terbium, thulium, and lutetium, being a mixture of these elements, or being mischmetal, and said compound being free of bismuth.

2. The thermoelectric compound according to claim 1, **characterized in that** the dopant is chosen from among yttrium, cerium, praseodymium, neodymium, gadolinium, and erbium, or is a mixture of these elements.

3. The thermoelectric compound according to claim 2, **characterized in that** the dopant is chosen from among cerium, praseodymium, neodymium, gadolinium, and erbium, or is a mixture of these elements.

4. The thermoelectric compound according to claim 1, **characterized in that** the dopant comprises a mixture of at least cerium, lanthanum, neodymium, and praseodymium.

5. The thermoelectric compound according to claim 1, **characterized in that** the dopant is mischmetal.

6. The thermoelectric compound according to any one of the preceding claims, **characterized in that** the atomic percentage of the dopant relative to the metallic elements is between 0.05 and 1.4% inclusive.

*Fig.1*

*Fig.2*

*Fig.3*

*Fig.4*

Fig.5

**Fig.6**

**Fig.7**

Fig. 8

Fig.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **OHNO et al.** Phase boundary mapping to obtain n-type Mg3Sb2-based thermoelectrics,. *Joule*, 2018, vol. 2, 141-154
- **ZHANG et al.** High-Performance Low-Cost n-Type Se-Doped Mg3Sb2-Based Zintl Compounds for Thermoelectric Application. *Chem. Mater.*, 2017, vol. 29, 5371-5383
- **TAMAKI et al.** Isotropic Conduction Network and Defect Chemistry in Mg3+$\delta$Sb2-Based Layered Zintl Compounds with High Thermoelectric Performance. *Adv. Mater.*, 2016, vol. 28, 10182-10187
- **CHEN et al.** Extraordinary thermoelectric performance in n-type manganese doped Mg3Sb2 Zintl: High band degeneracy, tuned carrier scattering mechanism and hierarchical microstructure. *Nano Energy*, 2018, vol. 52, 246-255
- Effective n-type doping of Mg3Sb2 with group-3 elements. **GORAI PRASHUN et al.** JOURNAL OF APPLIED PHYSICS. AMERICAN INSTITUTE OF PHYSICS, 08 January 2019, vol. 125